# EUROPEAN PATENT APPLICATION

(11) **EP 1 548 844 A1**
(43) Date of publication of application: **29.06.2005**
(21) Application number: 03766748.2
(22) Date of filing: 05.08.2003
(51) Int. Cl.: H01L 31/00, H01L 51/00, G02B 5/00, H05B 33/00

(54) **FILMS HAVING MULTILAYER HETEROSTRUCTURE, PROCESS FOR PRODUCING THE SAME AND OPTICAL DEVICES USING THE SAME**

(30) Priority: 06.08.2002 JP 2002228582; 06.08.2002 JP 2002228583
(71) Applicant: Bridgestone Corporation, Tokyo 104-8340 (JP)
(72) Inventor: SHIRATORI, Seimei, Shiratori NanoTechnology Co., Kawasaki-shi, Kanagawa 212-0054 (JP); MAEHARA, Yoshiki, Shiratori NanoTechnology Co., Kawasaki-shi, Kanagawa 212-0054 (JP); KOBAYASHI, Taichi, Bridgestone Corp., Tech. Center, Kodaira-shi, Tokyo 187-8531 (JP); YOSHIKAWA, Masato, Bridgestone Corp., Tech. Center, Kodaira-shi, Tokyo 187-8531 (JP)
(74) Representative: Whalley, Kevin
(86) International application number: PCT/JP2003/009935
(87) International publication number: WO 2004/013914

(57) **Abstract**

A film having a multilayer heterostructure which has at least one organic layer formed by self-assembly, **characterized in that** the organic layer contains from 1 to 100 mM of a sensitizing dye; and a film having a multilayer heterostructure which has at least one organic layer and at least one inorganic layer each formed by self-assembly, **characterized in that** the organic layer contains an aromatic compound. It is intended to provide these multilayer heterostructure films having advanced functions, a process for producing the same, and optical devices having advanced functions with the use of these films.

## Description

### TECHNICAL FIELD

The present invention relates to films having a multilayer heterostructure, optical devices using the same, and a process for producing the same, and more particularly to films having a multilayer heterostructure which are suitably applicable to optical devices such as reflection films, optical filters, optical resonators, EL (electroluminescent) devices, display devices and optical sensors, and a process for producing these films having a multilayer heterostructure which are formable over a large surface area of a substrate.

### BACKGROUND ART

Films having a multilayer heterostructure have such a structure that different kinds of materials are alternately laminated on each other, and suitably used as optical reflection films and optical transmission films as well as optical devices such as optical resonators, EL devices, display devices and optical sensors because of various optical properties thereof.

The respective layers of the films having a multilayer heterostructure are different in refractive index from each other since these layers are made of the different kinds of materials, so that reflection or refraction phenomenon occurs at boundary surfaces therebetween. Therefore, the change or modification in materials, thicknesses or number of the respective layers enables production of thin films having various optical properties.

There are conventionally known various methods for producing such films having a multilayer heterostructure. Examples of the production methods include dry methods such as vacuum deposition, sputtering and molecular beam epitaxy, and wet methods such as solution casting and spin-coating. The former methods are excellent in view of well-controlled film thickness, but requires a high temperature and a high vacuum, resulting in disadvantages such as difficulty in forming the films over a large surface area and high film formation costs. On the other hand, the latter methods are advantageously conducted at ordinary temperature and ordinary pressure, but difficult in controlling the film thickness.

To solve the above problems, Japanese Patent Application Laid-open No. 2001-350015 has proposed films having a multilayer heterostructure which are formed by alternately laminating a first layer obtained by a sol-gel method and a second layer obtained by an alternate adsorption method.

### DISCLOSURE OF THE INVENTION

An object of the present invention is to provide films having a multilayer heterostructure which are produced by improving the techniques described in Japanese Patent Application Laid-open No. 2001-350015, and exhibit advanced functions.

As a result of extensive researches for solving the conventional problems, the inventors have found that the above object is achieved by:
(1) A film having a multilayer heterostructure which comprises at least one organic layer formed by self-assembly wherein said organic layer contains from 1 to 100 mM of a sensitizing dye.
(2) The film having a multilayer heterostructure as defined in the above aspect (1) wherein said organic layer contains an aromatic compound.
(3) The film having a multilayer heterostructure as defined in the above aspect (1) or (2) which further comprises at least one inorganic layer formed by self-assembly.
(4) A film having a multilayer heterostructure which comprises at least one organic layer and at least one inorganic layer each formed by self-assembly wherein said organic layer contains an aromatic compound.
(5) The film having a multilayer heterostructure as defined in any of the above aspects (1) to (3) wherein said organic layer is formed by an alternate adsorption method.
(6) The film having a multilayer heterostructure as defined in any of the above aspects (3) to (5) wherein said inorganic layer is formed by a sol-gel method.
(7) The film having a multilayer heterostructure as defined in any of the above aspects (3) to (6) wherein said organic and inorganic layers are alternately laminated on each other.
(8) The film having a multilayer heterostructure as defined in any of the above aspects (1) to (7) wherein said organic layer is produced by alternate adsorption of a high-molecular compound having an aromatic ring and a high-molecular compound having a carboxyl group.
(9) The film having a multilayer heterostructure as defined in any of the above aspects (3) to (8) wherein said inorganic layer contains a titanium compound.
(10) A process for producing a film having a multilayer heterostructure, which comprises the step of laminating an organic layer containing an aromatic compound and a sensitizing dye on a substrate by self-assembly.
(11) The process for producing a film having a multilayer heterostructure as defined in any of the above aspect (10), which further comprises the step of laminating an inorganic layer by self-assembly in addition to said organic layer.
(12) A process for producing a film having a multilayer heterostructure, which comprises the step of laminating an organic layer containing an aromatic compound and an inorganic layer, respectively, on a substrate by self-assembly.
(13) The process for producing a film having a multilayer heterostructure as defined in any of the above aspects (10) to (12) wherein said organic layer is laminated by an alternate adsorption method.
(14) The process for producing a film having a multilayer heterostructure as defined in any of the above aspects (11) to (13) wherein said inorganic layer is laminated by a sol-gel method.
(15) The process for producing a film having a multilayer heterostructure as defined in any of the above aspects (11) to (14) wherein said organic and inorganic layers are alternately laminated on each other.
(16) The process for producing a film having a multilayer heterostructure as defined in any of the above aspects (10) to (15) wherein said organic layer is laminated by alternate adsorption of a high-molecular compound having an aromatic ring and a high-molecular compound having a carboxyl group.
(17) The process for producing a film having a multilayer heterostructure as defined in the aspect (16), which further comprises the steps of:
   dipping the substrate in an aqueous solution containing the high-molecular compound having an aromatic ring;
   dipping the substrate in an aqueous solution containing the high-molecular compound having a carboxyl group; and
   rinsing the substrate in a rinsing bath between the dipping steps.
(18) The process for producing a film having a multilayer heterostructure as defined in the above aspect (17) wherein at least one of said aqueous solution containing the high-molecular compound having an aromatic ring and said aqueous solution containing the high-molecular compound having a carboxyl group, contains a sensitizing dye.
(19) The process for producing a film having a multilayer heterostructure as defined in any of the above aspects (14) to (18) wherein said inorganic layer is laminated by a sol-gel method using a solution containing titanium alkoxide.
(20) An optical device using the film having a multilayer heterostructure as defined in any of the above aspects (1) to (9).
(21) An optical device using the film having a multilayer heterostructure which is produced by the process as defined in any of the above aspects (10) to (19).

The present invention has been accomplished on the basis of the above finding.

### BRIEF DESCRIPTION OF THE DRAWINGS

Fig. 1 is a view showing absorption spectra of organic thin films obtained in Examples 1 and 2 and Comparative Example 1.
Fig. 2 is a view showing electric current and voltage characteristics of the organic thin film obtained in Example 1 upon irradiating light thereto.
Fig. 3 is a view showing electric current and voltage characteristics of the organic thin film obtained in Example 2 upon irradiating light thereto.
Fig. 4 is a view showing electric current and voltage characteristics of the organic thin films obtained in Examples 1 and 2 and Comparative Example 1 upon irradiating light thereto.
Fig. 5 is a view showing absorption spectra of the film having a multilayer heterostructure which was obtained in Example 3.
Fig. 6 is a view showing electric current and voltage characteristics of the film having a multilayer heterostructure which was obtained in Example 3 upon irradiating light thereto.

### BEST MODE FOR CARRYING OUT THE INVENTION

The film having a multilayer heterostructure according to the present invention is characterized in that the film includes at least one organic layer formed by self-assembly, and the organic layer contains a sensitizing dye.

In addition, the film having a multilayer heterostructure according to the present invention is also characterized in that the film include at least one organic layer and at least one inorganic layer each formed by self-assembly, and the organic layer contains an aromatic compound.

The sensitizing dye used herein means such a dye capable of increasing a sensitivity to light even when added in a small amount, namely enhancing a photoelectric effect. In view of the case where the film is applied to photoelectric devices, the sensitizing dye to be added to the organic layer preferably exhibits light absorption in a visible light range. Specific examples of the sensitizing dye include phthalocyanine-based compounds, porphyrin-based compounds, rhodamine-based compounds, perylene-based compounds, cyanine-based compounds, merocyanine-based compounds and xanthene-based compounds. Of these compounds, preferred are phthalocyanine-based compounds, and most preferred is copper phthalocyanine since this compound has a maximum absorption in a wavelength range of 600 to 700, and is inexpensive.

In the present invention, the amount of the sensitizing dye added is in the range of 0.001 to 100 mM and preferably 1 to 10 mM in view of effects attained by the addition thereof.

The "self-assembly" used herein means a method for forming a film owing to a self-assembling nature of molecules, etc., due to attraction forces such as electrostatic attraction force, so that organic substances and/or inorganic substances are self-assembled and formed into a thin film. More specifically, as the self-assembly method, there are known alternate adsorption method, sol-gel method, chemical solution precipitation method, in-situ polymerization method (polymerization adsorption method), Langmuir-Blodgeti method, etc. In the present invention, it is preferred that the organic layer is formed by alternate adsorption method, and the inorganic layer is formed by sol-gel method.

The alternate adsorption method means such a technique in which a substrate is alternately dipped in a solution containing positively-charged particles and a solution containing negatively-charged particles to form a thin film having a multilayer structure. In general, the surface of the substrate is first subjected to hydrophilic treatment to introduce OH- groups thereinto, thereby imparting negative charges as initial surface charges thereto. Then , the substrate having the thus negatively charged surface is dipped in the solution containing positively-charged particles to adsorb the positively-charged particles onto the surface of the substrate by Coulomb's force therebetween, so that the positively charged particles adsorbed are formed into a thin film on the surface of the substrate. Further, the thus treated substrate is dipped in the solution containing negatively-charged particles to form the negatively-charged particles into a layer-like thin film on an outside of the thin film composed of the positively-charged particles. These procedures are alternately repeated to form a composite thin film having a multilayer structure in which the thin film made of the positively-charged particles and the thin film made of the negatively-charged particles are alternately laminated on the substrate.

In the present invention, the organic layer preferably contains an aromatic compound. More preferably, the aromatic compound is used as the positively-charged particles. The organic layer containing the aromatic compound has advantages such as good absorptivity to ultraviolet rays, visible lights and infrared rays, good electric conductivity and emission of fluorescence and phosphor. The aromatic compound used herein means a high-molecular compound mainly having an aromatic ring. Specific examples of the aromatic compound include poly-p-phenylene vinylene and precursors thereof such as acid salts of poly(xylydene-tetrahydrothiophenium), polyaniline, polypyrrole, polythiophene, poly-p-phenylene and polypyridine. Of these aromatic compounds, especially preferred are acid salts of poly(xylydene-tetrahydrothiophenium), polyaniline and polypyrrole.

On the other hand, the negatively-charged particles used in the present invention are not particularly limited as long as they are capable of alternate adsorption with the positively-charged particles. Examples of the preferred negatively-charged particles include high-molecular compounds having a carboxyl group. Specific examples of such high-molecular compounds include polyacrylic acid and polymethacrylic acid.

Meanwhile, the alternate adsorption conditions such as particle concentrations of the solutions containing the positively-charged particles and the negatively-charged particles, respectively, pH thereof upon the treatment, and adsorption time may be appropriately determined according to film thickness, functions to be imparted to the film, etc.

Also, in the alternate adsorption method, since the substrate is alternately dipped in the solution containing the positively-charged particles and the solution containing the negatively-charged particles, these solutions tend to be contaminated. To avoid this defect, the substrate is preferably subjected to a rinsing step between the respective steps of dipping the substrate in the solution containing the positively-charged particles and the solution containing the negatively-charged particles.

The film having a multilayer structure according to the present invention preferably further comprises at least one inorganic layer formed by self-assembly in addition to the above organic layer. In addition, as described previously, the self-assembly of the inorganic layer is preferably conducted by sol-gel method.

The sol-gel method used herein generally means such a method in which a solution containing an organic or inorganic metal compound is subjected to hydrolysis or polycondensation reaction of the compound to convert the sol into a gel, and then the resultant gel is dried to obtain a solid metal oxide.

In the present invention, similarly to the alternate adsorption method, the surface of the substrate is also first covered with a specific reactive group (e.g., OH- groups). Then, the substrate is dipped in an aqueous solution containing a metal compound to be adsorbed onto the substrate, thereby allowing the metal or the metal compound to be chemically adsorbed to the reactive groups present on the surface of the substrate. Next, the metal compound adsorbed onto the surface of the substrate is hydrolyzed and converted into a sol state. Thereafter, the surface of the substrate is dried to convert the metal compound in the form of sol into a gel state and further convert the gel into a solid metal compound.

Meanwhile, a rinsing step for the substrate is preferably conducted between the chemical adsorption step and the hydrolysis step for the purpose of removing an excess amount of the metal compound attached to the surface of the substrate.

In general, in the sol-gel method, there may be frequently used a solution containing a metal alkoxide. In the present invention, there may also be suitably used such a metal alkoxide. The metal alkoxide is a metal compound represented by the chemical formula: M(OR)ₙ wherein M is metal; and R is an alkyl group. Specific examples of the metal M include titanium, silicon, zirconium, aluminum, barium, lithium, niobium, potassium, tantalum, indium, tin, sodium and boron. These metals may be used singly or in combination of any two or more thereof. Examples of the metal alkoxides containing the combination of metals include alkoxides of indium-tin, boron-silicon, silicon-titanium, etc. In the present invention, the use of metal alkoxides containing titanium as M is preferred, and the inorganic layer is preferably in the form of a thin film containing titanium oxide.

The film having a multilayer heterostructure according to the present invention is produced by alternately subjecting the same substrate to the step of forming mainly the organic layer, for example, by alternate adsorption method and the step of forming mainly the inorganic layer, for example, by sol-gel method. The layer to be first formed and the method used therefor as well as the layer to be last formed and the method therefor are optional, and may be appropriately determined according to kind of the aimed film having a multilayer heterostructure and functions to be imparted thereto.

Meanwhile, when the film-forming step by alternate adsorption method is shifted to the film-forming step by sol-gel method and vice versa, it is preferred that a desired amount of electric charges still remain on the surface of the substrate. This is because the step of introducing OH⁻ groups into the surface of the substrate before forming the respective layers can be omitted to thereby simplify the respective steps.

The film having a multilayer heterostructure according to the present invention is applicable to reflection films and transmission films as well as other optical devices. In particular, the film having a multilayer heterostructure whose organic layer contains the aromatic compound and the sensitizing dye may be suitably applied to photoelectric devices.

Also, the film having a multilayer heterostructure which includes at least one organic layer containing an aromatic compound and at least one inorganic layer which layers are respectively formed by self assembly is effectively applied to optical devices such as optical resonators, EL devices, display devices and optical sensors.

### EXAMPLES

The present invention will be described in more detail by reference to the following examples. However, it should be noted that the following examples are only illustrative and not intended to limit the invention thereto.

### EXAMPLE 1

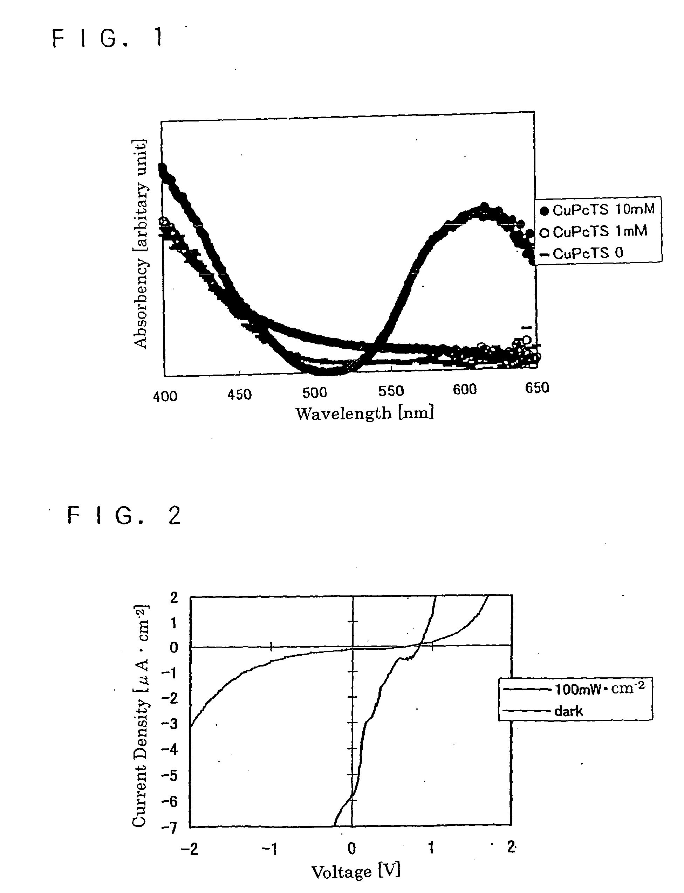

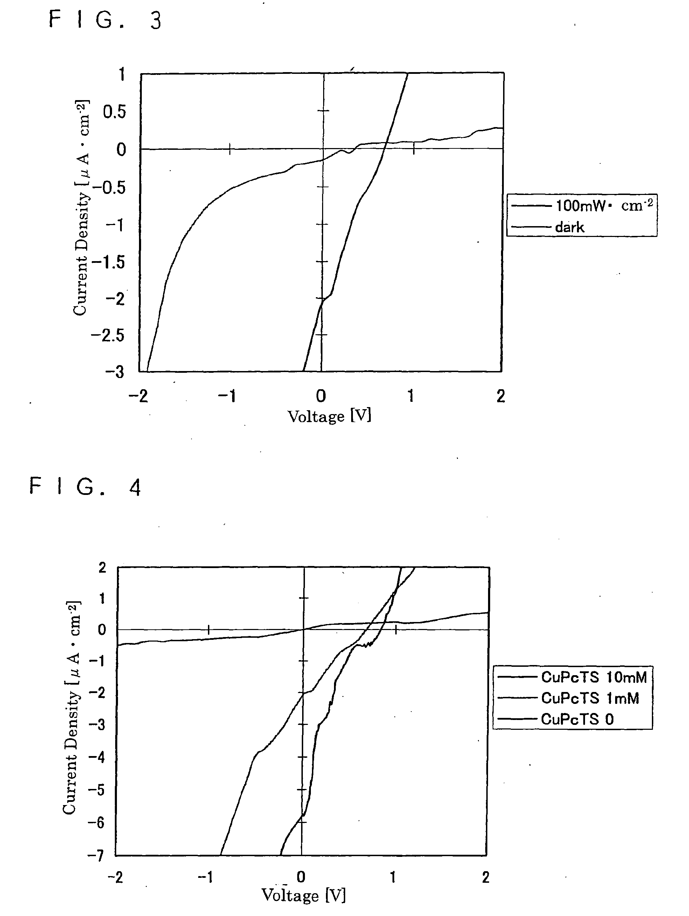

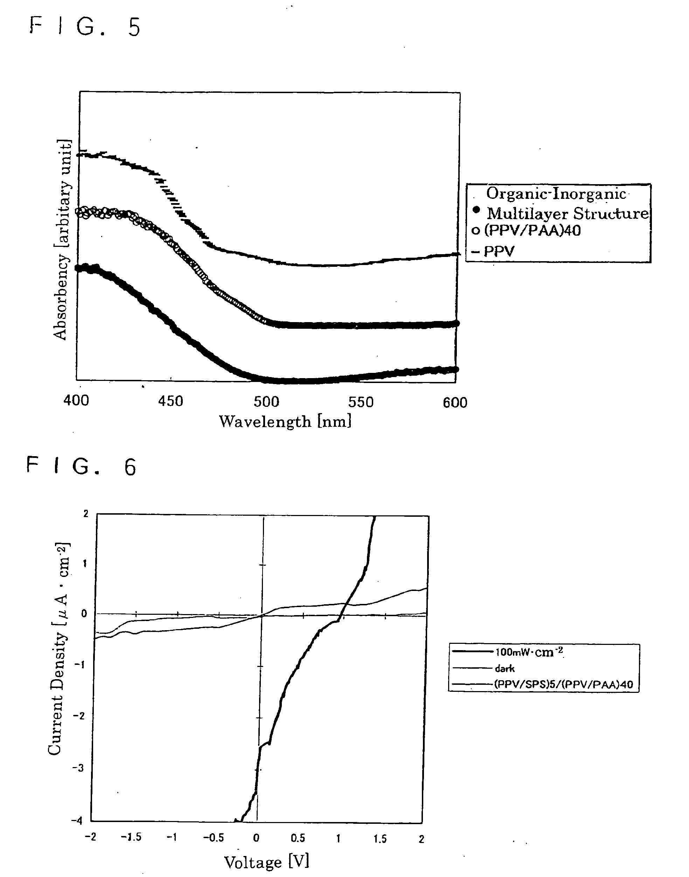

(1) The surface of an ITO substrate was subjected to hydrophilic treatment with an ethanol solution of potassium hydroxide (KOH) to introduce OH- groups thereinto, thereby imparting negative charges as initial surface charges onto the surface of the substrate. The thus treated substrate was alternately dipped in an aqueous solution containing 1 mM of poly(xylydene-tetrahydrothiophenium) chloride represented by the following formula (I) (hereinafter referred to merely as "PXT") and an aqueous solution containing 10 mM of poly(sodium-4-styrenesulfonate) (hereinafter referred to merely as "SPS") five times for each solution to subject the surface of the substrate to alternate adsorption. Meanwhile, PXT was a precursor of poly(p-phenylene vinylene) (hereinafter referred to merely as "PPV"), and SPS was subjected to alternate adsorption with PPV in order to enhance uniformity of the resultant thin film. The dipping treatment with the respective solutions was performed at room temperature for 3 min while maintaining a pH thereof at 3.5. 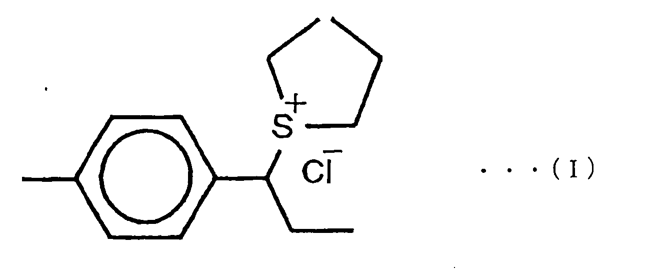 P X T ; Poly(xylydene-tetrahydrothiophenium 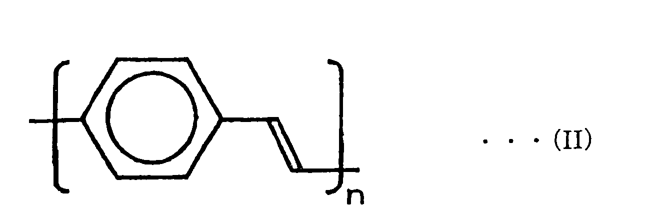 P P V ; Poly(p-phenylene vinylene)
(2) Next, the thus treated ITO substrate was rinsed in a rinsing bath of ultrapure water for 2 min twice, and then alternately dipped in the same PXT aqueous solution as used in the above (1) and an aqueous solution containing 10 mM of polyacrylic acid represented by the following formula (III) (hereinafter referred to merely as "PAA") and 10 mM of copper (II) phthalocyanine-sodium tetrasulfonate represented by the following formula (IV) (hereinafter referred to merely as "CuPcTS") 40 times for each solution to thereby subject the substrate to alternate adsorption. The dipping treatment with the respective solutions was performed at room temperature for 3 min while maintaining a pH thereof at 3.5. 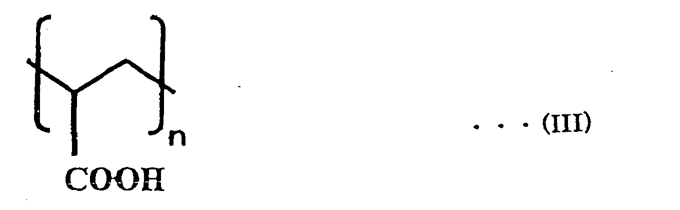 P A A ; Poly(acrylic acid) 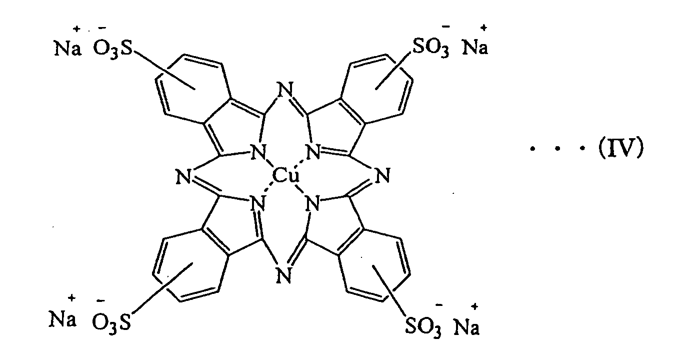
(3) After completion of the alternate adsorption, the ITO substrate thus provided thereon with the organic thin film was heat-treated at 230°C for 180 min. It was confirmed that the ITO substrate with the organic thin film had such a structure represented by ITO/(PPV/SPS)₅/(PPV/(PAA + CuPcTS))₄₀. The visible light absorption spectrum of the organic thin film was measured by an ordinary method. The results are shown in Fig. 1. Further, Al was vacuum-deposited on the organic thin film, and the Al-deposited organic thin film was subjected to measurements of current and voltage under the light-irradiation and non-irradiation conditions. The irradiation of light was performed using a halogen lamp with an output power of 100 mW·cm⁻². The results are shown in Figs. 2 and 4 and Table 1.

From Fig. 1, it was confirmed that the organic thin film obtained in Example 1 exhibited a maximum absorption attributed to CuPcTS at a wavelength near 620 nm in addition to the spectrum attributed to PPV. In addition, the visual observation showed that the organic thin film had a blue color due to CuPcTS, and no yellowish green fluorescence due to PPV was observed.

### EXAMPLE 2

The same procedure as in EXAMPLE 1 was repeated except that the concentration of CuPcTS was changed to 1 mM, thereby obtaining an organic thin film. The visible light absorption spectrum, current and voltage of the thus obtained organic thin film were measured. The results are shown in Figs. 1, 3 and 4 and Table 1.

As a result, it was confirmed that since the organic thin film obtained in EXAMPLE 2 had a low CuPcTS concentration, no maximum absorption was observed at a wavelength near 620 nm, and the visual observation of the organic thin film showed no difference from the organic thin film obtained in COMPARATIVE EXAMPLE 1 below.

### COMPARATIVE EXAMPLE 1

The same procedure as in EXAMPLE 1 was repeated except that no CuPcTS was added, thereby obtaining an organic thin film. The visible light absorption spectrum, current and voltage of the thus obtained organic thin film were measured. The results are shown in Figs. 1 and 4.

**TABLE 1**

| | Example 1 | Example 2 |
|---|---|---|
| Short circuit current Jsc (µA·cm⁻¹) | 5.82 | 2.08 |
| Release voltage Voc (mV) | 831 | 638 |
| Curve factor FF | 0.150 | 0.247 |
| Conversion efficiency η (%) | 0.000751 | 0.000328 |

As a result, it was confirmed that the irradiation of light from the halogen lamp produced a photoelectromotive force in the organic thin film.

### EXAMPLE 3

(1) An ITO substrate was subjected to the same treatment as in EXAMPLE 1(1).
(2) Next, the thus treated ITO substrate was rinsed in a rinsing bath of ultrapure water for 2 min twice, and then alternately dipped in the same PXT aqueous solution as used above and an aqueous solution containing 10 mM of PAA represented by the above formula (III) 10 times for each solution to thereby subject the substrate to alternate adsorption. The dipping treatment with the respective solutions was performed at room temperature for 3 min while maintaining a pH thereof at 3.5.
   As a result, it was confirmed that the ITO substrate provided thereon with an organic layer by the above steps had such a structure that the surface thereof was covered with COO- groups.
(3) Next, the thus treated ITO substrate was dipped in a 2-propanol solution containing 100 mM of titanium butoxide represented by the formula: Ti(O-nBu)₄ wherein Bu represents butyl, at room temperature for 3 min. Next, the ITO substrate was rinsed with 2-propanol for 3 min twice, and then transferred into a water vessel and hydrolyzed therein for 3 min. Thereafter, the thin film formed on the ITO substrate was heat-treated at 230°C for 180 min. It was confirmed that the obtained inorganic layer was made of titania (TiO₂).

The respective steps of forming the organic and inorganic layers were repeated four times, thereby producing the ITO substrate formed thereon with the thin film having such a structure represented by ITO/(PPV/SPS)₅/(PPV/PAA)₁₀/TiO₂)₄.

The visible light absorption spectrum of the obtained thin film was measured by an ordinary method. The results are shown in Fig. 5. Further, Al was vacuum-deposited on the thin film, and the Al-deposited thin film was subjected to measurements of current and voltage under the light-irradiation and non-irradiation conditions. The irradiation of light was performed using a halogen lamp with an output power of 100 mW·cm⁻². The results are shown in Fig. 6 and Table 2.

**TABLE 2**

| | Example 3 |
|---|---|
| Short circuit current Jsc (µA·cm⁻¹) | 2.81 |
| Release voltage Voc (mV) | 962 |
| Curve factor FF | 0.173 |
| Conversion efficiency η (%) | 0.000467 |

### INDUSTRIAL APPLICABILITY

The film having a multilayer heterostructure according to the present invention can be readily formed over a large surface area, and can be applied to various optical devices owing to its good photoelectric effect.

## Claims

1. A film having a multilayer heterostructure, comprising at least one organic layer formed by self-assembly, said organic layer containing from 0.001 to 100 mM of a sensitizing dye.

2. The film according to claim 1, wherein said sensitizing dye exhibits light absorption in a visible light range.

3. The film according to claim 1 or 2, wherein said sensitizing dye is a copper phthalocyanine-based compound.

4. The film according to any of claims 1 to 3, wherein said organic layer contains an aromatic compound.

5. The film according to any of claims 1 to 4, further comprising at least one inorganic layer formed by self-assembly.

6. A film having a multilayer heterostructure, comprising at least one organic layer and at least one inorganic layer each formed by self-assembly, wherein said organic layer contains an aromatic compound.

7. The film according to any of claims 1 to 6, wherein said organic layer is formed by an alternate adsorption method.

8. The film according to any of claims 5 to 7, wherein said inorganic layer is formed by a sol-gel method.

9. The film according to any of claims 5 to 8, wherein said organic and inorganic layers are alternately laminated on each other.

10. The film according to any of claims 4 to 9, wherein said aromatic compound is a high-molecular compound having an aromatic ring.

11. The film according to any of claims 1 to 10, wherein said organic layer is produced by alternate adsorption of a high-molecular compound having an aromatic ring and a high-molecular compound having a carboxyl group.

12. The film according to any of claims 5 to 11, wherein said inorganic layer contains a titanium compound.

13. A process for producing a film having a multilayer heterostructure, comprising the step of laminating an organic layer containing an aromatic compound and a sensitizing dye on a substrate by self-assembly.

14. The process according to claim 13, wherein said sensitizing dye exhibits light absorption in a visible light range.

15. The process according to claim 13 or 14, wherein said sensitizing dye is a copper phthalocyanine-based compound.

16. The process according to any of claims 13 to 15, further comprising the step of laminating an inorganic layer on the substrate by self-assembly in addition to said organic layer.

17. A process for producing a film having a multilayer heterostructure, comprising the step of respectively laminating an organic layer containing an aromatic compound and an inorganic layer on a substrate by self-assembly.

18. The process according to any of claims 13 to 17, wherein said organic layer is laminated by an alternate adsorption method.

19. The process according to any of claims 16 to 18, wherein said inorganic layer is laminated by a sol-gel method.

20. The process according to any of claims 16 to 19, wherein said organic and inorganic layers are alternately laminated on each other.

21. The process according to any of claims 13 to 20, wherein said organic layer is laminated by alternate adsorption of a high-molecular compound having an aromatic ring and a high-molecular compound having a carboxyl group.

22. The process according to claim 21, further comprising the steps of:
dipping the substrate in an aqueous solution containing the high-molecular compound having an aromatic ring;
dipping the substrate in an aqueous solution containing the high-molecular compound having a carboxyl group; and
rinsing the substrate in a rinsing bath between the dipping steps.

23. The process according to claim 22, wherein at least one of said aqueous solution containing the high-molecular compound having an aromatic ring and said aqueous solution containing the high-molecular compound having a carboxyl group, contains a sensitizing dye.

24. The process according to any of claim 19 to 23, wherein said inorganic layer is laminated by a sol-gel method using a solution containing titanium alkoxide.

25. The process according to claim 24, further comprising the steps of:
dipping the substrate in the solution containing titanium alkoxide;
hydrolyzing the titanium alkoxide adsorbed onto the substrate; and
rinsing the substrate in a rinsing bath between the dipping and hydrolyzing steps.

26. An optical device using the film having a multilayer heterostructure as claimed in any of claims 1 to 12.

27. An optical device using the film having a multilayer heterostructure which is produced by the process as claimed in any of claims 13 to 25.
